# EUROPEAN PATENT SPECIFICATION

(11) **EP 3 565 135 B1**
(45) Date of publication and mention of the grant of the patent: **27.04.2022**
(21) Application number: 18170041.0
(22) Date of filing: 30.04.2018
(51) Int. Cl.: H04B 7/04

(54) **SYSTEM AND METHOD FOR INVERTING A RADIO CHANNEL FOR BROADBAND SIGNALS**
SYSTEM UND VERFAHREN ZUM INVERTIEREN EINES FUNKKANALS FÜR BREITBANDSIGNALE
SYSTÈME ET PROCÉDÉ POUR INVERSER UN CANAL RADIO DE SIGNAUX À LARGE BANDE

(43) Date of publication of application: 06.11.2019
(73) Proprietor: Rohde & Schwarz GmbH & Co. KG, 81671 München (DE)
(72) Inventor: Köbele, Johannes, 81827 München (DE)
(74) Representative: Rupp, Christian

(56) References cited:
- EP-A1- 2 432 073
- EP-A1- 3 054 743
- EP-A1- 3 293 897
- WO-A1-2014/197185
- WO-A1-2015/042336
- US-A1- 2006 009 185
- US-A1- 2011 200 084
- US-A1- 2014 218 240
- US-B1- 8 526 550
- Ya Jing ET AL: "MIMO OTA Testing Based on Transmit Signal Processing", IEEE Instrumentation & Measurement Magazine, 1 June 2016 (2016-06-01), pages 43-50, XP055521500, Retrieved from the Internet: URL:https://ieeexplore.ieee.org/stamp/stam p.jsp?tp=&arnumber=7477954 [retrieved on 2018-11-06]

## Description

The invention relates to a measurement system adapted to invert a radio channel for a broadband signal. The system comprises a device under test with at least two antennas, and at least two measurement probes.

To enable the measurement system for measuring broadband signals, the signals of the measurement probes each comprise a relative delay.

In order to increase data throughput multiple-input multiple-output (MIMO) techniques have been developed over the past years. MIMO is a method for multiplying the capacity of a radio link using multiple transmit and receive antennas to exploit multipath propagation. MIMO has become an important element of wireless communication standards. Hence, MIMO over-the-air (OTA) measurement for terminal performance evaluation has become more and more important. MIMO test methods can be divided into two main groups: one based on anechoic chambers and the other based on reverberation chambers. Measurement methods related to anechoic chambers exemplarily include the ring of probes method, the multi-probe method, the two-channel method and the two-stage method. The two-stage method is one of the methods proposed for standard organizations. However, the original proposal for the two-stage method did not support over-the-air (OTA) measurements and thus, radiated interference entering the device under test (DUT) from its transmitter or other sources of noise was not measured.

Document R4-66AH-0012 presented at the 3GPP Meeting RAN4#66-AH-MIMO-OTA in Munich, Germany, 12-13 March 2013, by Agilent Technologies, Tri-L Solutions with the title "Incorporating self-interference into the two-stage method" is related to an alternative two-stage method that supports over-the-air measurements. The document can be downloaded under the following link: http://www.3gpp.org/ftp/tsg ran/wg4 radio/TSGR4 AHs/TSGR4 66-AH-MIMO-OTA/Docs/. The cited document, hereinafter referred to as R4-66AH-0012 discloses that in a first stage the antenna pattern of the device under test (DUT) is measured. In a second stage, a calibrated radiated connection in an anechoic chamber is provided instead of using a cable connection as known from the original two-stage method. This replacement of the cable connection is achieved by measuring the MIMO propagation conditions in the anechoic chamber between the test system transmit antennas and the device under test (DUT) receive antennas. According to R4-66AH-0012, the inverse of this channel is then applied to the test signals in order to create a transmission channel representing an identity matrix, whereby a high degree of isolation (>20db) is achieved between the transmit and receive antenna pairs as was naturally the case when using cabled connections.

Even though, the cited document discloses that due to precoding of the transmitted signals it is possible, by calculating the radiated channel matrix and by applying its inverse to the transmitted signals, to create an identity matrix allowing the transmitted signals to be received independently at each antenna, the document is silent regarding the signal properties of the signal to be transmitted, such as bandwidth. Document R4-66AH-0012 does not recognize that beside parameters such as amplitude and phase, additional parameters such as path-loss delay, delay/amplitude/phase of multipath components, frequency-dependency and so on have to be considered when performing channel inversion. Thus, the cited document is silent that with increasing bandwidth the isolation between the transmit- and receive antenna pairs is reduced to values below 20dB. Since bandwidth is anticipated to increase for future communication systems, it is critical to provide a measurement system and method that ensures acceptable isolation parameters even for signals with increasing bandwidths.

Document WO 2014/197185 A1 discloses a method for facilitating wireless testing of a radio frequency signal transceiver device under test. Using multiple antennas within a shielded enclosure containing the device under test, multiple wireless radio frequency test signals resulting from a radio frequency test signal radiated from the device under test are captured and their respective signal phases are controlled prior to being combined to form a composite radio frequency signal.

Document EP 2 432 073 A1 discloses an antenna evaluation apparatus that includes receiving antennas to be evaluated, scatterer antennas provided around them, signal generators, delay circuits, dividers, phase-shift circuits, and attenuation circuits. A computer controls the delay circuits to add delay times to radio frequency signals, and controls the phase-shift circuits and attenuation circuits to change phases and amplitudes of the radio frequency signals to produce a first fading.

The object of the invention is to provide a measurement system and measurement method, which allow radio channel inversion even for broadband signals.

The object is solved by the features of the first independent claim for the system and by the features of the second independent claim for the method. Dependent claims contain further developments.

A measurement system is adapted to invert a radio channel for a broadband signal comprising a device under test with at least two antennas and comprising at least two measurement probes is provided. Said measurement probes are configured to each emit signals shifted in phase and amplitude. The signals emitted by the measurement probes are configured such that each of the signals comprises a relative delay. Advantageously, additionally to the use of complex amplitude (i.e. amplitude and phase) in order to invert the radio channel (i.e. separate the signals determined for each device under test receive antenna) the parameter of delay is used.

The signals emitted by the measurement probes are shifted in phase and amplitude and are delayed such that the signal intended for a specific antenna of the device under test is only received at said specific antenna and cancelled out at the remaining antennas of the device under test. Advantageously, the use of the delay as additional parameter to phase and amplitude shifting allows increasing the destructive interference (i.e. isolation) significantly. Especially for higher bandwidths the time delay is necessary to ensure that each antenna of the device under test only receives the desired signals and no other signals that negatively affect the measurement results. Thus, the additional time delay, especially for broadband signals, allows a destructive interference of unwanted signals at each antenna and ensures only the desired signals are received, respectively measured at the specific antenna.

Advantageously, the channel inversion of a physical radio channel between antennas of a device under test that shall receive signals (DUT receive antennas) from a measurement probe (probe antennas) is possible even for high bandwidth signals by adding a relative time delay to each signal emitted by the probe antennas, wherein the time delay takes into account the various distances between the different antenna and probe combinations and is therefore suitable to be used for various test setups with different device under test antenna locations and different measurement probe locations.

According to an embodiment, the delay is in the range of 0 to 0.5ns.

According to a further embodiment, at least the measurement probes and the device under test are located within an anechoic chamber. Advantageously, the anechoic chamber prevents disturbances from external influences and ensures reproducibility of measurements.

According to a further embodiment, the number of delayed signals of each one of the measurement probes can be varied.

According to a further embodiment the number of delayed signals is increased until a predefined signal compensation is reached. Advantageously, increasing the number of delayed signals reduces the amplitude of an unwanted remaining signal. Said remaining signal is called a residual component. With each further delayed signal, the amplitude of the residual component is reduced. A predefined signal compensation is determined by the defined allowable residual component. If the defined residual component is not small enough, a further delayed signal has to be emitted.

According to a further embodiment the number of delayed signals depends on the spatial arrangement between the antennas of the device under test and the measurement probes.

According to a further embodiment, the measurement system comprises a base station emulator and/or a channel emulator, wherein the channel emulator configures the measurement probes each have a relative time delay. Advantageously, using a base station and channel emulator, which are frequently used in standard setups for performance testing of communication devices, especially for devices for multiple-input multiple-output (MIMO) applications, allows the channel inversion of the physical radio channel between the DUT receive antenna and the probe antennas for signals with higher bandwidth in an easy and cost-effective way. This is just by adapting the channel emulator to generate a relative time delay between signals of the measurement probes. It is also conceivable that the base station emulator triggers the time delay.

According to a further embodiment, the signals are generated by a signal generator connected to a splitter distributing the signal to the measurement probes. At least one measurement probe is connected to a phase shifting unit and an attenuator or amplifier unit and to a signal delay unit to configure the signals emitted by the measurement probe.

A method for adapting a measurement system to invert a radio channel for a broadband signal is provided. The method comprises the step of configuring measurement probes of a measurement system to each emit signals shifted in phase and amplitude with the aid of a phase shifting and attenuation or amplification unit. The method further comprises the step of configuring the signals of the measurement probes such that each signal comprises a relative delay. It is also conceivable that the phase and amplitude shifting functionality and the time delay functionality are implemented within a base station emulation unit or within as channel emulator unit.

According to an embodiment, the method further comprises the step of shifting the signals emitted by the measurement probes in phase and amplitude, and delaying the signals emitted by the measurement probes relative to each other such that the signal intended for a specific antenna of a device under test is only received at said specific antenna and cancelled out at the remaining antennas of the device under test.

Further, the relative time delay for each of the measurement probe signals is determined empirically by varying the delay time for each measurement probe signal based on the feedback of the measurement result at the antennas of the device under test. Advantageously, since in most cases the antenna configuration of a device under test is not exactly known, the determination of the relative delay time of the measurement probe signals is determined based on measurement results at each device under test antenna. Such measurement indicated for the delay time can be the measurement of the power of the signal that shall be received by the device under test antenna, a bit error rate (BER) measurement of the device under test or any other suitable measurement. When the measurement results are not acceptable, the time delay is varied and the measurement is repeated until a desired measurement result is achieved.

According to a further embodiment, the method further comprises the step of determining a delay in the range of 0 to 0.5ns.

According to a further embodiment, the method further comprises the step of increasing the number of delayed signals until a predefined signal compensation is reached.

Exemplary embodiments of the invention are now further explained with regard to the drawings by way of example only and not for limitation. In the drawings
- Fig. 1: shows an embodiment of a radiated-two-stage test setup;
- Fig. 2: shows an embodiment of the measurement system according to the first aspect of the invention;
- Fig. 3: shows an embodiment of time delayed signals emitted from measurement probes to reduce residual components at antennas of the device under test (DUT antennas);
- Fig. 4: shows an embodiment of a simulation of maximum achievable isolation by changing the phase of one probe antenna and for a small signal bandwidth based on the measurement setup depicted in Fig. 2;
- Fig. 5: shows an embodiment of a simulation of maximum achievable isolation by changing the phase of one probe antenna and for a medium signal bandwidth based on the measurement setup depicted in Fig. 2;
- Fig. 6: shows an embodiment of a simulation of maximum achievable isolation by changing the phase of one probe antenna and for a large signal bandwidth based on the measurement setup depicted in Fig. 2; and
- Fig. 7: shows an embodiment of the measurement method according to the second aspect of the invention.

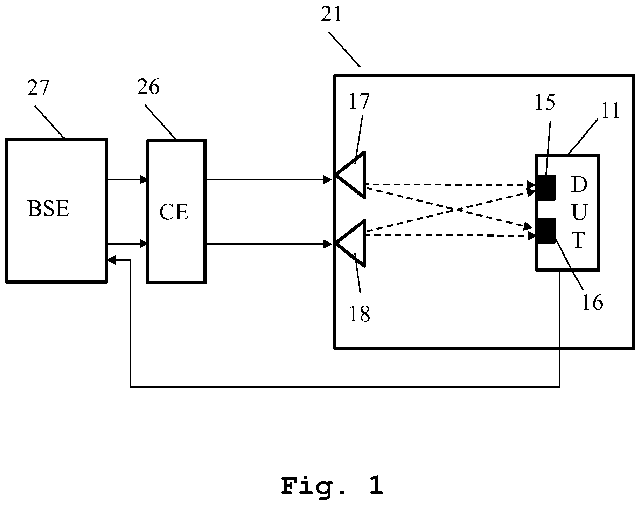

In Fig. 1, an embodiment of a radiated two-stage (RTS) test setup is shown. The radiated two-stage method (RTS) measures both, the patterns of the device under test (DUT) and the multiple-input multiple-output (MIMO) throughput performance. The setup includes two measurement probes 17, 18, hereinafter also named measurement antennas, probe antennas or measurement antenna probes. The setup further includes a user equipment (UE) 11 also named a device under test (DUT) 11 that is equipped with two antennas 15, 16. The device under test 11 and the measurement probes 17, 18 are located within an anechoic chamber 21. The two probe antennas 17, 18 with polarization V and H are co-located within said anechoic chamber 21. Due to the propagation channel between the measurement probes 17, 18 and the antennas 15, 16 of the device under test 11, signals transmitted from each probe antenna 17, 18 are received by each antenna 15, 16 of the user equipment 11. The measurement probes 17, 18 are connected to a channel emulator (CE) 26, which is further connected to a base station emulator (BSE) 27. The device under test 11 is additionally connected for example via a cable connection or a wireless connection to the base station emulator (BSE) 27. The signals generated by the base station emulator (BSE) 27 are modified by the channel emulator (CE) 26 according to a predefined channel model, in order to simulate real-word conditions. With the aid of the base station emulator (BSE) 27 and the channel emulator (CE) 26 performance testing of the device under test 11 according to various test standards can be conducted. The connection from the device under tests 11 to the base station emulator 27 allows to modify the setting of the base station emulator 27 based on measurements performed by the device under test 11.

Thus, it is critical to isolate the signals from each other in the second stage of the two-stage measurement to be able to perform an accurate measurement.

In a first stage, the antenna pattern of the antennas of the device under test is measured with the test setup.

In a second stage, the transmitted signals are precoded using spatial multiplexing techniques and using results of the antenna pattern measurement, which allows to calculate the radiated channel matrix and to apply the inverse of said radiated channel matrix to the transmitted signals. By doing so, an identity matrix is created allowing the transmitted signals to be received independently at each antenna.

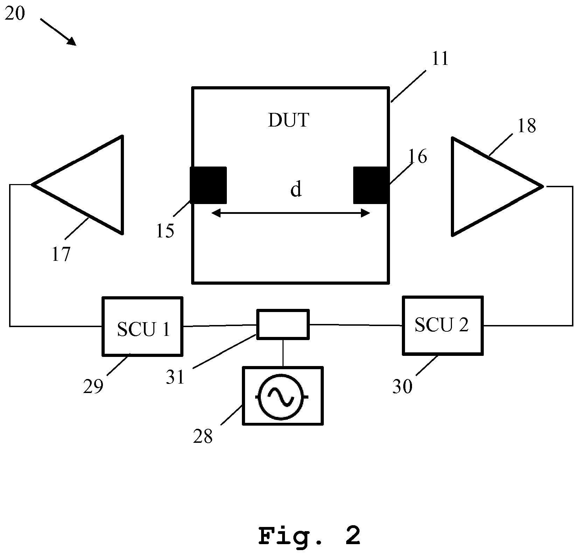

In Fig. 2, an embodiment of the measurement system 20 according to the first aspect of the invention is shown. Fig. 2 shows the device under test (DUT) 11 including two antennas 15, 16. According to Fig. 2, the two antennas 15, 16 are located opposite to each other and have a distance d from each other. The distance d preferably for example is about 15cm. The embodiment further shows a signal generator 28 that is connected to a signal splitter 31 that equally splits the input signal from the signal generator 28 in two output signals. The outputs of the signal splitter 31, are each connected to a signal condition unit 29, 30. The expression signal condition unit means a unit that includes a phase shifting unit, an attenuator and/or an amplifier unit and further, a signal delay unit. The outputs of the signal condition units 29, 30 are each connected to a measurement probe 17 and a measurement probe 18. The measurement probes 17, 18 are also called measurement antennas or probe antennas and are preferably located on the opposite walls of an anechoic chamber (not shown).

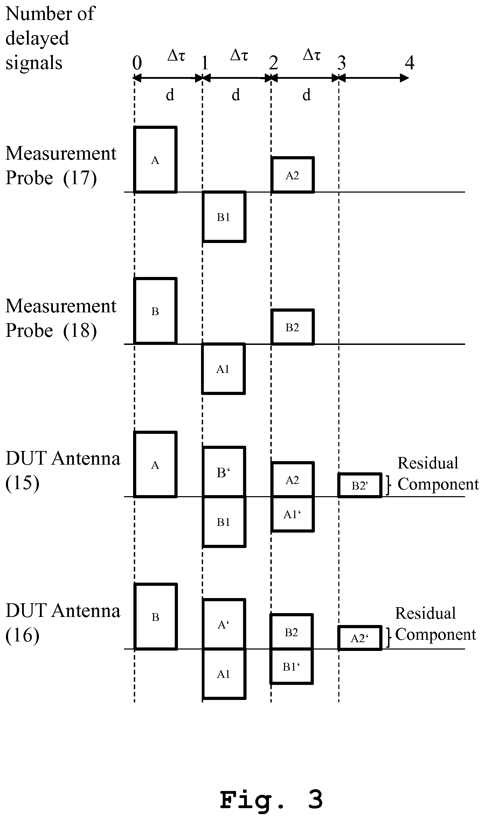

Is also possible to just provide one signal condition unit 29. However, in order to explain the signal delay concept in Fig. 3, two signal condition units 29, 30 are depicted for the sake of clarity. Each signal condition unit 29, 30 is capable of shifting the amplitude and/or phase of a signal received at its input, and the signal condition unit 29, 30 is additionally capable of delaying the signal received at its input. The signal generator 28 preferably generates broadband signals, preferably higher than for example 100MHz.

In Fig. 3, the concept of delaying signals emitted by the measurement probes 17, 18 and the received signals at each antenna 15, 16 of the device under test (DUT) 11 is described based on Fig. 2.

Fig. 3 shows a data stream A, emitted by the measurement probe 17 and a data stream B, emitted by the measurement probe 18. Data stream A shall be received only by the antenna 15 of the device under test 11, in other words, data stream A shall only be measured at antenna 15. Data stream B shall be received only by the antenna 16 of the device under test 11, in other words, data stream B shall only be measured at antenna 16.

However, since data stream A travels across the device under test and also passes antenna 16 of the device under test 11, antenna 16 receives a fraction of data stream A, named A', after a time delay Δτ depending on the distance d between antennas 15 and 16 of the device under test 11, as depicted in Fig. 2. Analogously, antenna 15 of the device under test 11, receives a fraction of data stream B, named B', after a time delay Δτ depending on the distance d as depicted in Fig. 2.

The fraction of data stream B received at antenna 15 is depicted by a block named B' and the fraction of data stream A received at antenna 16 is depicted by a block named A'. The fraction of data stream A, named A' and the fraction of data stream B, named B' are delayed with respect to their originating data streams A and B by a value Δτ.

Without any further compensation measures, in other words without any further delayed signal, antenna 15 would receive and measure a data stream A and additionally a fraction of a data stream B, named data stream B' having the same orientation as B, but with a reduced amplitude and a time delay Δτ with respect to data stream B.

This analogously applies for antenna 16, which would receive and measure a data stream B and additionally a fraction of a data stream A, named data stream A' having the same orientation as A, but with a reduced amplitude and a time delay Δτ with respect to data stream A.

Data stream B' received at antenna 15 and data stream A' received at antenna 16 are called residual components in case no further data stream is emitted by measurement probe 17 and 18. In order to compensate for said residual components, one or more delayed signals are provided by measurement probes 17, 18.

In this embodiment, measurement probe 17 emits a data stream B1, having a time delay Δτ with respect to data stream A. This is a first delayed signal emitted by measurement probe 17. Said delay depends on the distance d between antenna 15 and 16 of the device under test 11. Data stream B1 has the same amplitude than data stream B' but an opposite orientation, in other words the data stream B1 emitted by measurement probe 17 is phase shifted according to 180° or π.

Since data stream B1 is delayed by Δτ, data stream B1 and data stream B' are received by antenna 15 of the device under test 11 at the same time. Since said data stream B1 and data stream B' further have the same amplitude and opposite orientation destructive interference is taking place and B' and B1 are cancelled out at antenna 15. This analogously applies for antenna 16, where data stream A1 and data stream A' interfere with each other and any component of data stream A' and A1 is cancelled out at antenna 16.

However, a fraction of data stream A1, named A1', emitted by measurement probe 18 to compensate for data stream A', is received at antenna 15 having a time delay Δτ with respect to the data stream A1, having a reduced amplitude compared to A1 and having the same orientation as data stream A1. In order to compensate for said data stream A1', measurement probe 17 emits a data stream A2. This is a second delayed signal emitted by measurement probe 17. Said data stream A2 has opposite orientation with respect to A1', but the same amplitude than data stream A1'. Furthermore, data stream A2 has a delay Δτ with respect to data stream B1.

Since data stream A2 is delayed by Δτ, data stream A1' and data stream A2 are received by antenna 15 of the device under test 11 at the same time. Since said data stream A2 and data stream A1' further have the same amplitude and opposite orientation, destructive interference is taking place and A1' and A2 are cancelled out at antenna 15. This analogously applies for antenna 16, where data stream B2 and data stream B1' interfere with each other and any component of data stream B1' and B2 is cancelled out at antenna 16.

Finally, according to the embodiment shown in Fig. 3, no additional data stream is emitted by measurement probe 17 or 18. In other words the number of delayed signals emitted by measurement probes 17 and 18 is two, as depicted in Fig. 2.

A fraction of data stream B2 emitted by measurement probe 18 is received at antenna 15 having a reduced amplitude compared to data stream B2 and having a delay Δτ with respect to data stream B2. Since no further compensation signal is emitted by measurement probe 17, the remaining data stream is called residual component B2'. Analogously, a fraction of data stream A2 is received at antenna 16 having a reduced amplitude compared to data stream A2 and having a delay Δτ with respect to data stream A2. Since no further compensation signal is emitted by measurement probe 18, the remaining data stream is called residual component A2'.

It is obvious from Fig. 3 that with each further delayed signal emitted by measurement probes 17, 18 the residual component decreases. The number of delayed signals can be increased until a predetermined residual component value is achieved. In other words, the number of delayed signals is increased until a predefined signal compensation is reached.

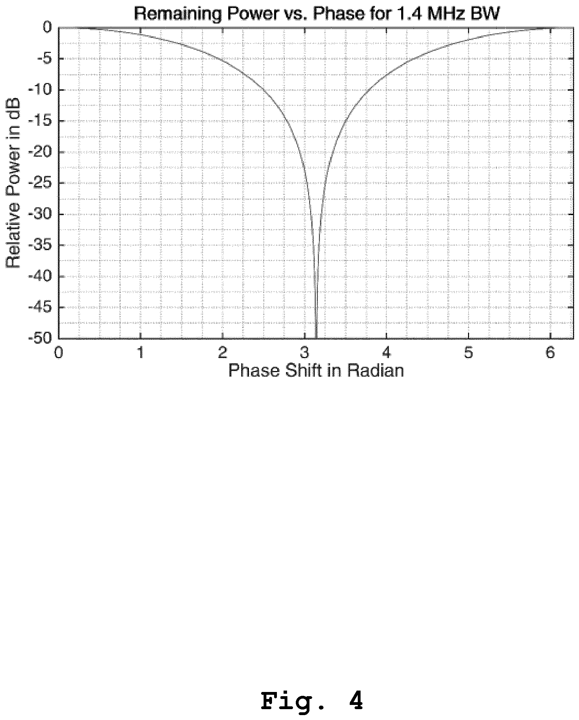

Fig. 4 to 6 show an embodiment of a simulation of maximum achievable isolation by changing the phase of one probe antenna and for different signal bandwidths based on the measurement setup depicted in Fig. 2.

Figs. 4 to 6 show a simulation result for antenna 15 of device under test 11. Due to symmetry in the simulation setup according to Fig. 2, the results for antenna 16 of device under test 11 are equivalent. In order to investigate maximum achievable isolation, the phase of probe antenna 18 is changed between 0 and 2π (2pi). Since path loss is not simulated in this setup, the signals originating from probe 17 and 18 reach antenna 15 of the device under test 11 with the same power. The simulation results show the remaining power after summation of the two signals in relation to the relative phase shift of probe antenna 18. The distance d between the two antennas 15, 16 of the device under test 11 is 15cm in this example.

As shown in Fig. 2 the probe antennas 17, 18 are located on the opposite walls of an anechoic chamber (not shown). In terms of relative delay, the setup according to Fig. 2 represents the worst case assumption (maximum delay). No reflections are simulated, thus a fully anechoic chamber is assumed. Furthermore, path loss between antenna 15 and 16 of the device under test 11 is ignored, i.e. probe 17 and probe 18 are far away from the device under test 11.

Fig. 4 shows a simulation result for a small signal bandwidth of 1.4MHz. At a phase shift of approx. 3,14 radian (Pi), which equals a phase shift of 180°, the remaining power is very small. As can be seen in Fig. 4 the relative power in dB is -50dB. In other words signals with a bandwidth up to 1.4MHz show a clear effect of destructive interference at a phase shift of 180° respectively 3,14 radian (Pi), which means that high isolation values are achievable for signals with such a bandwidth.

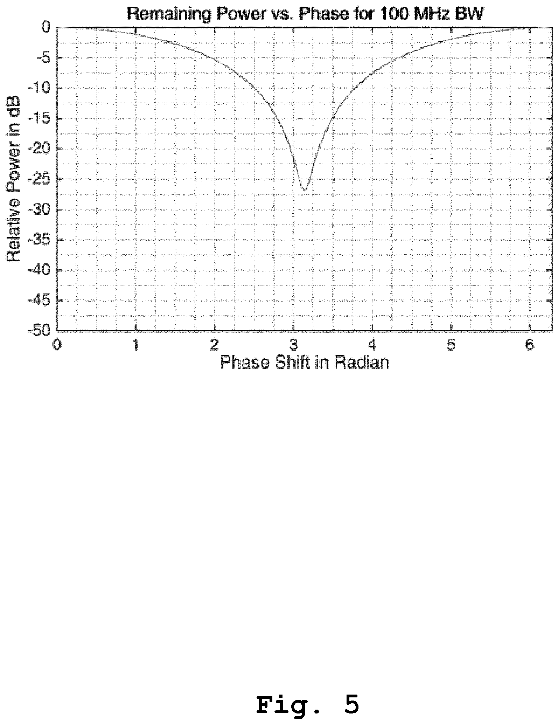

Fig. 5 shows a simulation result for a medium signal bandwidth of 100MHz. At a phase shift of approx. 3,14 radian (Pi), which equals a phase shift of 180°, the remaining power is still small. As can be seen in Fig. 5 the relative power in dB is -27dB. In other words signals with a bandwidth up to 100MHz show a clear effect of destructive interference at a phase shift of 180° respectively 3,14 radian (Pi), which means that high isolation values are achievable for signals with such a bandwidth.

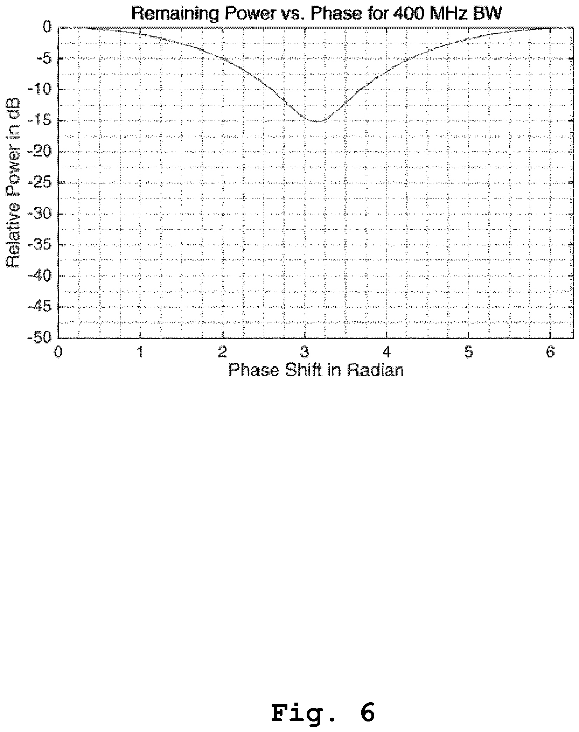

Fig. 6 shows a simulation result for a relatively high signal bandwidth of 400Hz. At a phase shift of approx. 3,14 radian (Pi), which equals a phase shift of 180°, the remaining relative power in dB is -15dB, which clearly shows that the maximum achievable isolation is reduced.

The simulation results of Figs. 4 to 6 show that increasing the bandwidth of the simulated signal results in a decreased maximum achievable isolation when only optimizing phase (and power). The simulations in Fig. 4 to 6 show that according to finding of the present invention there clearly is a need for a system and method that allows channel inversion for higher bandwidths. According to the simulation results, higher bandwidths are bandwidths above 100MHz.

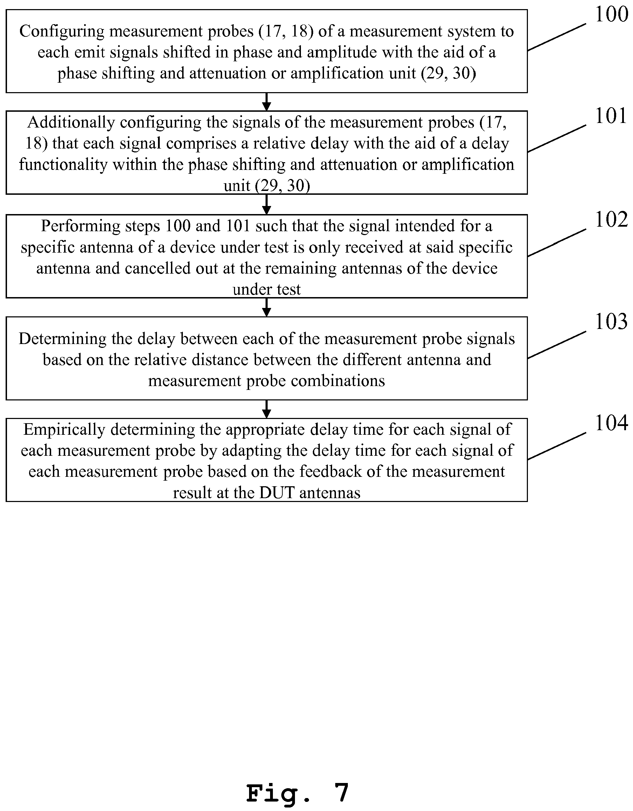

In Fig. 7, an embodiment of the method for adapting a measurement system according to the second aspect of the invention is shown. In a first step 100 measurement probes 17, 18 of a measurement system are configured to each emit signals shifted in phase and amplitude with the aid of a phase shifting and attenuation or amplification unit 29, 30. It is also conceivable to perform the signal amplitude and phase shift with the aid of standard component of a measurement system such as a base station emulator or a channel emulator.

In a second step 101 the signals of the measurement probes 17, 18, in other words the signals to be emitted by the measurement probes, are configured such that each signal comprises a relative delay with the aid of a delay functionality within the phase shifting and attenuator or amplification unit 29, 30. It is also conceivable that said delay functionality is provided within the base station emulator or channel emulator.

In a third step 102 the steps 100 and 101 are performed such that the signal intended for a specific antenna 15, of a device under test 11 is only received at said specific antenna 15 and cancelled out at the remaining antennas 16 of the device under test 11.

In a fourth step 103 the relative delay between each of the measurement probe signals is determined based on the relative distance between the different antenna and measurement probe combinations.

Finally, in a fifth step 104 the relative time delay for each of the measurement probe signals is determined empirically by varying the delay time for each measurement probe signal based on the feedback of the measurement result at the antennas of the device under test 11.

The invention is not limited to the examples and especially not to specific types of devices under test.

While various embodiments of the present invention have been described above, it should be understood that they have been presented by way of example only, and not limitation. Numerous changes to the disclosed embodiments can be made in accordance with the disclosure herein without departing from the scope of the invention. Thus, the scope of the present invention should not be limited by any of the above described embodiments. Rather, the scope of the invention should be defined in accordance with the following claims.

## Claims

1. A measurement system (20) adapted to use delay in addition to complex amplitude to invert a radio channel for a broadband signal, the system comprising:
- a device under test (11) with at least two antennas (15, 16), and
- at least two measurement probes (17, 18),
wherein said measurement probes (17, 18) are configured to each emit signals shifted in phase and amplitude,
wherein the signals emitted by the measurement probes (17, 18) are configured such that each of the signals comprises a relative delay,
and wherein the relative delay for each of measurement probe (17, 18) signals is determined empirically by varying the delay time for each measurement probe (17, 18) signal based on the feedback of the measurement result at the antennas (15, 16) of the device under test (11).

2. The system according to claim 1,
wherein the signals emitted by the measurement probes (17, 18) are shifted in phase and amplitude and are delayed such that the additional time delay allows a destructive interference of unwanted signals at each antenna (15, 16) and ensures that only the desired signals are received and measured at the specific antenna (15, 16).

3. The system according to any of claims 1 or 2, wherein the delay is in the range of 0 to 0.5ns.

4. The system according to any of claims 1 to 3,
wherein at least the measurement probes (17, 18) and the device under test (11) are located within an anechoic chamber (21).

5. The system according to any of claims 1 to 4,
wherein the number of delayed signals of each one of the measurement probes (17, 18) can be varied.

6. The system according to claims 5,
wherein the number of delayed signals is increased until a predefined signal compensation is reached.

7. The system according to claim 5,
wherein the number of delayed signals depends on the spatial arrangement between the antennas (15, 16) of the device under test (11) and the measurement probes (17, 18) .

8. The system according to any of claims 1 to 7,
wherein the measurement system comprises a base station emulator (27) and/or a channel emulator (26), wherein the channel emulator (26) configures the measurement probes (17, 18) each having a relative time delay.

9. The system according to any of claims 1 to 7,
wherein the signals are generated by a signal generator (28) connected to a splitter (31) distributing the signal to the measurement probes (17, 18), and/or
wherein at least one measurement probe (17, 18) is connected to a phase shifting unit (29) and an attenuator or amplifier unit (29) and to a signal delay unit (29) to configure the signals emitted by the measurement probe (17, 18).

10. A method for adapting a measurement system to use delay in addition to complex amplitude to invert a radio channel for a broadband signal, the method comprising the steps of:
configuring measurement probes (17, 18) of a measurement system to each emit signals shifted in phase and amplitude with the aid of a phase shifting and attenuation or amplification unit (29, 30),
configuring the signals of the measurement probes (17, 18) such that each signal comprises a relative delay, and
determining the relative delay for each of measurement probe (17, 18) signals empirically by varying the delay time for each measurement probe (17, 18) signal based on the feedback of the measurement result at the antennas (15, 16) of the device under test (11).

11. The method according to claim 10,
wherein the method further comprises the step of shifting the signals emitted by the measurement probes (17, 18) in phase and amplitude, and
delaying the signals emitted by the measurement probes relative to each other such that the additional time delay allows a destructive interference of unwanted signals at each antenna (15, 16) and ensures that only the desired signals are received and measured at the specific antenna (15, 16).

12. The method according to any of claims 10 or 11, wherein the method further comprises the step of determining a delay in the range of 0 to 0.5ns.

13. The method according to any of claims 10 to 12, wherein the method further comprises the step of increasing the number of delayed signals until a predefined signal compensation is reached.

## Patentansprüche

1. Messsystem (20), das angepasst ist, zusätzlich zu einer komplexen Amplitude eine Verzögerung zu verwenden, um einen Funkkanal für ein Breitbandsignal umzuwandeln, wobei das System Folgendes umfasst:
- eine zu testende Vorrichtung (11) mit mindestens zwei Antennen (15, 16), und
- mindestens zwei Messsonden (17, 18),
wobei die Messsonden (17, 18) dazu ausgelegt sind, jeweils phasen- und amplitudenverschobene Signale zu emitieren,
wobei die Signale, die von den Messsonden (17, 18) emittiert werden, derart ausgelegt sind, dass jedes der Signale jeweils eine relative Verzögerung umfasst,
und wobei die relative Verzögerung für jedes der Signale der Messsonden (17, 18) durch Variieren der Verzögerungszeit für jedes der Signale der Messsonden (17, 18) auf Basis der Rückmeldung des Messergebnisses an den Antennen (15, 16) der zu testenden Vorrichtung (11) empirisch bestimmt wird.

2. System nach Anspruch 1,
wobei die Signale, die von den Messsonden (17, 18) emittiert werden, phasen- und amplitudenverschoben und derart verzögert sind, dass die zusätzliche Zeitverzögerung eine destruktive Störung von unerwünschten Signalen an jeder Antenne (15, 16) ermöglicht und sicherstellt, dass nur die gewünschten Signale an der spezifischen Antenne (15, 16) empfangen und gemessen werden.

3. System nach einem der Ansprüche 1 oder 2,
wobei die Verzögerung im Bereich von 0 bis 0,5 ns liegt.

4. System nach einem der Ansprüche 1 bis 3,
wobei sich mindestens die Messsonden (17, 18) und die zu testende Vorrichtung (11) in einer reflexionsarmen Kammer (21) befinden.

5. System nach einem der Ansprüche 1 bis 4,
wobei die Anzahl von verzögerten Signalen von jeder der Messsonden (17, 18) variiert werden kann.

6. System nach Anspruch 5,
wobei die Anzahl von verzögerten Signalen erhöht wird, bis eine vordefinierte Signalkompensation erreicht ist.

7. System nach Anspruch 5,
wobei die Anzahl von verzögerten Signalen von der räumlichen Anordnung zwischen den Antennen (15, 16) der zu testenden Vorrichtung (11) und den Messsonden (17, 18) abhängig ist.

8. System nach einem der Ansprüche 1 bis 7,
wobei das Messsystem einen Basisstationsemulator (27) und/oder einen Kanalemulator (26) umfasst, wobei der Kanalemulator (26) die Messsonden (17, 18) auslegt, die jeweils eine relative Zeitverzögerung aufweisen.

9. System nach einem der Ansprüche 1 bis 7,
wobei die Signale von einem Signalgenerator (28) erzeugt werden, der mit einem Splitter (31) verbunden ist, der das Signal an die Messsonden (17, 18) verteilt, und/oder
wobei mindestens eine Messsonde (17, 18) mit einer Phasenverschiebungseinheit (29) und einer Dämpfungs- oder Verstärkereinheit (29) und mit einer Signalverzögerungseinheit (29) verbunden ist, um die Signale, die von der Messsonde (17, 18) emittiert werden, auszulegen.

10. Verfahren zum Anpassen eines Messsystems zur Verwendung einer Verzögerung zusätzlich zu einer komplexen Amplitude, um einen Funkkanal für ein Breitbandsignal umzuwandeln, wobei das Verfahren die folgenden Schritte umfasst:
Auslegen von Messsonden (17, 18) eines Messsystems zum jeweiligen Emittieren von phasen- und amplitudenverschobenen Signalen mithilfe einer Phasenverschiebungs- und Dämpfungs- oder Verstärkungseinheit (29, 30),
Auslegen der Signale der Messsonden (17, 18) derart, dass sie jeweils eine relative Verzögerung umfassen, und
empirisches Bestimmen der relativen Verzögerung für jedes der Signale der Messsonden (17, 18) durch Variieren der Verzögerungszeit für jedes der Signale der Messsonden (17, 18) auf Basis der Rückmeldung des Messergebnisses an den Antennen (15, 16) der zu testenden Vorrichtung (11).

11. Verfahren nach Anspruch 10,
wobei das Verfahren ferner den Schritt des Phasen- und Amplitudenverschiebens der Signale, die von den Messsonden (17, 18) emittiert werden, umfasst, und
relatives Verzögern der Signale, die von den Messsonden emittiert werden, gegeneinander derart, dass die zusätzliche Zeitverzögerung eine destruktive Störung von unerwünschten Signalen an jeder Antenne (15, 16) ermöglicht und sicherstellt, dass nur die gewünschten Signale an der spezifischen Antenne (15, 16) empfangen und gemessen werden.

12. Verfahren nach einem der Ansprüche 10 oder 11,
wobei das Verfahren ferner den Schritt des Bestimmens einer Verzögerung im Bereich von 0 bis 0,5 ns umfasst.

13. Verfahren nach einem der Ansprüche 10 bis 12, wobei das Verfahren ferner den Schritt des Erhöhens der Anzahl von verzögerten Signalen, bis eine vordefinierte Signalkompensation erreicht ist, umfasst.

## Revendications

1. Système de mesure (20) adapté pour utiliser un retard en plus d'une amplitude complexe pour inverser un canal radio pour un signal à large bande, le système comprenant :
- un dispositif à l'essai (11) avec au moins deux antennes (15, 16), et
- au moins deux sondes de mesure (17, 18),
dans lequel lesdites sondes de mesure (17, 18) sont configurées pour émettre chacune des signaux décalés en phase et en amplitude,
dans lequel les signaux émis par les sondes de mesure (17, 18) sont configurés de sorte que chacun des signaux comprenne un retard relatif,
et dans lequel le retard relatif pour chacun des signaux de sonde de mesure (17, 18) est déterminé de manière empirique en faisant varier le temps de retard pour chaque signal de sonde de mesure (17, 18) sur la base du retour du résultat de mesure au niveau des antennes (15, 16) du dispositif à l'essai (11).

2. Système selon la revendication 1,
dans lequel les signaux émis par les sondes de mesure (17, 18) sont décalés en phase et en amplitude et sont retardés de sorte que le temps de retard supplémentaire permette une interférence destructive de signaux non désirés au niveau de chaque antenne (15, 16) et garantisse que seuls les signaux désirés soient reçus et mesurés au niveau de l'antenne (15, 16) spécifique.

3. Système selon l'une quelconque des revendications 1 ou 2,
dans lequel le retard se situe dans la plage de 0 à 0,5 ns.

4. Système selon l'une quelconque des revendications 1 à 3,
dans lequel au moins les sondes de mesure (17, 18) et le dispositif à l'essai (11) sont situés à l'intérieur d'une chambre anéchogène (21).

5. Système selon l'une quelconque des revendications 1 à 4,
dans lequel il est possible de faire varier le nombre de signaux retardés de chacune des sondes de mesure (17, 18).

6. Système selon la revendication 5,
dans lequel le nombre de signaux retardés est augmenté jusqu'à ce qu'une compensation de signal prédéfinie soit atteinte.

7. Système selon la revendication 5,
dans lequel le nombre de signaux retardés dépend de l'agencement spatial entre les antennes (15, 16) du dispositif à l'essai (11) et les sondes de mesure (17, 18).

8. Système selon l'une quelconque des revendications 1 à 7,
dans lequel le système de mesure comprend un émulateur de station de base (27) et/ou un émulateur de canal (26), dans lequel l'émulateur de canal (26) configure les sondes de mesure (17, 18) ayant chacune un retard temporel relatif.

9. Système selon l'une quelconque des revendications 1 à 7,
dans lequel les signaux sont générés par un générateur de signaux (28) connecté à un diviseur (31) répartissant le signal sur les sondes de mesure (17, 18), et/ou
dans lequel au moins une sonde de mesure (17, 18) est connectée à une unité de décalage de phase (29) et à une unité d'atténuation ou d'amplification (29) et à une unité de retardement de signal (29) pour configurer les signaux émis par la sonde de mesure (17, 18).

10. Procédé pour adapter un système de mesure afin d'utiliser un retard en plus d'une amplitude complexe pour inverser un canal radio pour un signal à large bande, le procédé comprenant les étapes consistant à :
configurer des sondes de mesure (17, 18) d'un système de mesure pour émettre chacune des signaux décalés en phase et en amplitude à l'aide d'une unité de décalage de phase et d'atténuation ou d'amplification (29, 30),
configurer les signaux des sondes de mesure (17, 18) de sorte que chaque signal comprenne un retard relatif, et
déterminer le retard relatif pour chacun des signaux de sonde de mesure (17, 18) de manière empirique en faisant varier le temps de retard pour chaque signal de sonde de mesure (17, 18) sur la base du retour du résultat de mesure au niveau des antennes (15, 16) du dispositif à l'essai (11).

11. Procédé selon la revendication 10,
dans lequel le procédé comprend en outre l'étape consistant à décaler les signaux émis par les sondes de mesure (17, 18) en phase et en amplitude, et
retarder les signaux émis par les sondes de mesure les uns par rapport aux autres, de sorte que le temps de retard supplémentaire permette une interférence destructive de signaux non désirés au niveau de chaque antenne (15, 16) et garantisse que seuls les signaux désirés soient reçus et mesurés au niveau de l'antenne (15, 16) spécifique.

12. Procédé selon l'une quelconque des revendications 10 ou 11,
dans lequel le procédé comprend en outre l'étape consistant à déterminer un retard dans la plage de 0 à 0,5 ns.

13. Procédé selon l'une quelconque des revendications 10 à 12, dans lequel le procédé comprend en outre l'étape consistant à augmenter le nombre de signaux retardés jusqu'à ce qu'une compensation de signal prédéfinie soit atteinte.
